# EUROPEAN PATENT APPLICATION

(11) **EP 4 462 634 A1**
(43) Date of publication of application: **13.11.2024**
(21) Application number: 24157557.0
(22) Date of filing: 14.02.2024
(51) Int. Cl.: H02J 7/00, H02H 3/087, H02H 7/18, H01L 31/16

(54) **BATTERY PROTECTION DEVICE AND BATTERY PACK INCLUDING THE SAME**

(30) Priority: 02.05.2023 KR 20230057216
(71) Applicant: Samsung SDI Co., Ltd., Yongin-si, Gyeonggi-do 17084 (KR)
(72) Inventor: LEE, Younghyun, Yongin-si 17084 (KR); JIN, Kyongpil, Yongin-si (KR)
(74) Representative: Marks & Clerk LLP

(57) **Abstract**

A battery protection device (200) includes a first transistor (M1), a switch control circuit (210), a controller (240), and a photocoupler (230). The first transistor (M1) is connected between one of the pack terminals (P+, P-) of a battery pack (10a) and a battery module (100) and controls a current flow between the pack terminals (P+, P-) and the battery module (100). The switch control circuit (210) outputs a first control signal (S1) for turning on or turning off the first transistor (M1). The controller (240) outputs a second control signal (S2). The photocoupler (230) is connected to a control terminal of the first transistor (M1), is turned on or turned off according to the second control signal (S2), and turns off the first transistor (M1) if turned on.

## Description

### BACKGROUND

### 1. Field

Embodiments relate to a battery protection device and a battery pack including the same.

### 2. Description of the Related Art

A secondary battery is different from a primary battery providing only an irreversible conversion of chemicals into electric energy in that the secondary battery can be repeatedly charged and discharged. Low-capacity secondary batteries are used as a power supply of small electronic devices such as mobile phones, laptop computers, and camcorders, and high-capacity secondary batteries are used as the power supply of hybrid or electric vehicles.

### SUMMARY

Embodiments are directed to a battery protection device that may include a first transistor connected between one of pack terminals and a battery module and controlling flow of a current between the pack terminals and the battery module. Also included may be a switch control circuit for outputting a first control signal for turning on or turning off the first transistor. Also included may be a controller for outputting a second control signal; and a photocoupler connected to a control terminal of the first transistor, the photocoupler being turned on or turned off according to the second control signal, and turning off the first transistor if the photocoupler is turned on.

The pack terminals may be terminals of a battery pack comprising the battery module and the battery protection device. The first transistor is connected between one of the pack terminals and the battery module. The pack terminals are connected to a load of the battery pack.

The first transistor is turned on or off in dependence upon a signal applied to the control terminal of the first transistor, wherein the signal is dependent upon the first control signal. The control terminal may comprise at least one of a gate and a base of the first transistor. The first transistor may be a field effect transistor having a source and drain and the control terminal may be a gate of the field effect transistor.

The first control signal may be received by a driving circuit of the battery protection device, wherein the driving circuit is configured to provide a signal applied to the control terminal to turn on or off the first transistor.

The photocoupler may comprise a light emitting element and a phototransistor (which is a light-receiving element), the phototransistor being connected to the control terminal. The phototransistor may be connected between the control terminal and a source terminal of the first transistor. The light-emitting element may generate light in dependence upon the second control signal. The phototransistor may be switched on in response to this light, so as to switch off the first transistor.

In an embodiment, the controller may turn on the photocoupler according to the second control signal if the current between the pack terminals and the battery module is greater than or equal to a setting value, and the first transistor may be turned off irrespective of the first control signal if the photocoupler is turned on.

In an embodiment, the first transistor may be connected between a positive pack terminal from among the pack terminals and a positive module terminal of the battery module.

In an embodiment, the first transistor may be realized as an N-channel metal oxide semiconductor electric field effect transistor including a drain terminal connected to the positive module terminal, a source terminal connected to the positive pack terminal, and a gate terminal used as the control terminal.

An embodiment may further include a driving circuit connected between the gate terminal and the source terminal and adjusting a voltage applied to the gate terminal according to the first control signal.

In an embodiment, the driving circuit may include a first resistor connected between a node for receiving the first control signal and the source terminal, and a second resistor connected between the node and the gate terminal.

In an embodiment, the driving circuit may further include a Zener diode connected between the source terminal and the node and controlling a voltage between the gate terminal and the source terminal.

In an embodiment, the photocoupler may include a light-emitting device for controlling light emission by the second control signal, and a light receiving element connected between the gate terminal and the source terminal, the light receiving element being turned on by light emission of the light-emitting device, and connecting the gate terminal and the source terminal if the light receiving element is turned on. The light-emitting device may emit light in dependence upon the second control signal. The light-receiving element may be configured to turn-on in response to the light from the light-emitting device.

An embodiment may further include a light-emitting control circuit connected between the light-emitting device and an output end of the controller, and intercepting or allowing a current flow of the light-emitting device according to the second control signal.

In an embodiment, the light-emitting control circuit may include a second transistor on a current path including the light-emitting device, and allowing or intercepting a current flowing to the light-emitting device according to the second control signal.

In an embodiment, the second transistor may include a first terminal connected to the light-emitting device, a second terminal connected to a ground, and a control terminal for receiving the second control signal; and the light-emitting device may be connected between a power node and the first terminal of the second transistor.

In an embodiment, the switch control circuit may include a charge pump circuit, and may generate the first control signal by using a voltage generated by the charge pump circuit.

In an embodiment, the switch control circuit may generate the first control signal for turning off the first transistor through the charge pump circuit if the current between the pack terminals and the battery module is greater than or equal to a setting value.

Another embodiment of the present disclosure provides a battery pack including: a battery module, and the battery protection device including at least one of the above-described characteristics.

At least some of the above and other features of the invention are set out in the claims.

### BRIEF DESCRIPTION OF THE DRAWINGS

Features will become apparent to those of ordinary skill in the art by describing in detail example embodiments with reference to the attached drawings, in which:
FIG. 1 illustrates a battery pack according to an example embodiment;
FIG. 2 is a circuit diagram illustrating a configuration of a battery protection device according to an example embodiment;
FIG. 3 is a timing diagram illustrating an operation of a battery protection device according to an example embodiment;
FIG. 4 is a circuit diagram illustrating a battery pack according to an example embodiment; and
FIG. 5 is a circuit diagram illustrating a battery pack according to an example embodiment.

### DETAILED DESCRIPTION

Hereinafter, embodiments of the present disclosure will be described in detail with reference to the accompanying drawings. An operation effect and a method of implementing the same according to embodiments of the present disclosure will be described with reference to the accompanying drawings. In the drawings, the same reference numerals denote the same elements, and redundant explanations will be omitted. However, the present disclosure may be embodied in various forms, and should not be construed as being limited only to the embodiments shown herein. Rather, these embodiments are provided by way of example to make the present disclosure thorough and complete, and will fully convey aspects and features of the present disclosure to those skilled in the art.

Accordingly, processes, elements, and techniques deemed not necessary to those skilled in the art for complete understanding of aspects and features may not be described. The relative sizes of elements and regions may be exaggerated for clarity.

As used herein, the term "and/or" includes any and all combinations of one or more related listed items. The use of "may" in describing an embodiment of the present disclosure indicates "at least one embodiment of the present disclosure". In the following description of embodiments of the present disclosure, terms in the singular form may include plural forms unless the context clearly indicates otherwise.

In the present specification, terms including ordinal numbers such as "first" and "second" are used to describe various components, but these components are not limited by these terms. The terms are only used to differentiate one component from other components. For example, without departing from the scope rights described in this document, a first component may be referred to as a second component, and similarly, the second component may also be renamed as the first component.

If one component or layer is described as "on" or "connected" for other components or layers, "on" or "connected" include all formed directly or by interposing one or more other components or layers. In addition, if it is disclosed that one component or a layer is "between" two components or layers, it should be appreciated that the corresponding component or layer is a single component or layer or there are one or more interposed other elements or layers.

Electric connection of two components includes not only a case where the two components are directly connected, but also a case where the two components are connected through another component interposed therebetween. Other components may include a switch, a resistor, a capacitor, and the like. In describing the embodiments, the expression "connection" means electrical connection unless there is an expression "direct connection".

Prior to describing embodiments of the present disclosure, a configuration of a battery pack relating to embodiments will now be described.

The battery pack may include at least one battery module and a pack housing having an accommodation space for accommodating the at least one battery module. If the battery pack includes battery modules, the battery modules may be connected in series and/or in parallel to each other.

The respective battery modules may include battery cells and a module housing. The battery cells may be connected in series and/or in parallel to each other, and may be received in the module housing in a stacked form.

The battery module may be configured into a cell stack in which battery cells are stacked. In this case, the cell stack may be received in the accommodation space in the pack housing or may be received in another accommodation space partitioned by a frame or a cell barrier in the pack housing.

The battery cell may include an electrode assembly including a positive electrode, a negative electrode, and a separator between the positive and negative electrodes, a case for accommodating the electrode assembly, and an electrode terminal electrically connected to the electrode assembly. An electrolyte may be injected into the case to enable charging and discharging of the battery cell through an electrochemical reaction by the positive electrode, the negative electrode, and the electrolyte solution. The battery cell may be classified into a circular type, a prismatic type, or a pouch type according to a case shape, and the case shape may depend on the use of the battery cell.

The battery cell may generate a large amount of heat during charging/discharging. The generated heat may accumulate in the battery cell and may accelerate deterioration of the battery cell. Accordingly, the battery pack may further include a cooling member to suppress the deterioration of the battery cells. The cooling member may be provided at a lower portion of the accommodation space where the battery cell may be provided, but may not be limited thereto, and may be provided at an upper portion top or a side of the accommodation space where the battery cell may be provided, depending on the battery pack.

Each battery cell may be configured such that exhaust gas inside the battery cell generated under an abnormal operating condition, also known as a thermal runaway or thermal event, is discharged to the outside of the battery cell. The battery pack or the battery module may be equipped with an exhaust port for discharging the exhaust gas to suppress damages to the battery pack or the battery module caused by the exhaust gas.

The battery pack may include a battery management system (BMS). The battery management system (BMS) may perform a battery state monitoring, a diagnosis, a control, a communication, and a protection function. The battery management system (BMS) may provide a charging and discharging state and a lifespan (or a state of health (SOH)) of the battery module or the battery cell.

The battery management system may include a detecting device, a balancing device, and a control device.

The detecting device may detect states (voltage, current, temperature, etc.) of the battery module or the battery cell, and may detect state information for indicating the states of the battery module or the battery cell. The detecting device may detect voltages of the respective battery cells or the respective battery modules. The detecting device may detect a current flowing through the battery module. The detecting device may detect a temperature and/or an adjacent temperature of the battery cell and/or battery module on at least one point of the battery pack or the battery module. The balancing device may perform a balancing operation of the battery module and/or the battery cells configuring the battery pack.

The control device may receive state information (voltage, current, temperature, etc.) of the battery module from the detecting device. The control device may monitor and calculate states (voltage, current, temperature, state of charge (SOC), lifespan (or state of health (SOH))) of the battery module based on the state information provided by the detecting device. Further, the control device may perform a control function (e.g., temperature control, balancing control, charge and discharge control) and a protection function (e.g., over-discharge, overcharge, overcurrent prevention, short-circuit, extinguishing function, etc.) based on a state monitoring result. For this purpose, the control device may include a charge and discharge control unit, a balancing control unit, and a protection unit. The control device may perform a wired or wireless communication function with an external device (e.g., an upper-level controller, a vehicle, a charger, or a PCS) of the battery pack.

The battery management system (BMS) may perform a function for controlling (switch controlling) power interception of the battery pack, a function for controlling a heat management (cooling, heating, etc.) of the battery pack, a function for interlocking a high voltage, and a function for detecting an insulating and short-circuit state.

The switch used for intercepting power of the battery pack may be a mechanical switch such as a relay or a contactor that may be turned on/off by a magnetic force of a coil, or a semiconductor switch such as a metal oxide semiconductor field effect transistor (MOSFET).

The switch controlling function of the battery management system (BMS) may include a function for intercepting power supply from the battery pack if a problem occurs in the vehicle and the battery pack. To this end, the battery pack may include at least one switch connected between the output terminals (a positive pack terminal and a negative pack terminal, collectively, pack terminals) of the battery pack and the battery module.

The switch controlling function of the battery management system (BMS) may include a pre-charge control function. Accordingly, the battery pack may further include a pre-charge switch and a pre-charge resistor connected between one of the output terminals of the battery pack and the battery module. The pre-charge control function may represent a function that connects a pre-charge resistor between the battery module and the load by operating the pre-charge switch before operating a main switch if starting the vehicle to prevent the inrush of an in-rush current, since there may be a risk of the inrush current occurring due to the high voltage capacitor on the input side of the inverter when connecting the battery pack and the load.

The battery pack may include a high voltage interlock circuit. The high voltage interlock circuit may use a signal to detect whether all high voltage parts are connected to the entire vehicle system, and the battery management system (BMS) may perform a high voltage interlock function for forcibly opening the switch when a break occurs in one place on the entire loop of the high voltage interlock circuit.

A battery protection device according to one or more embodiments, and a battery pack including the same will now be described in detail with reference to necessary drawings.

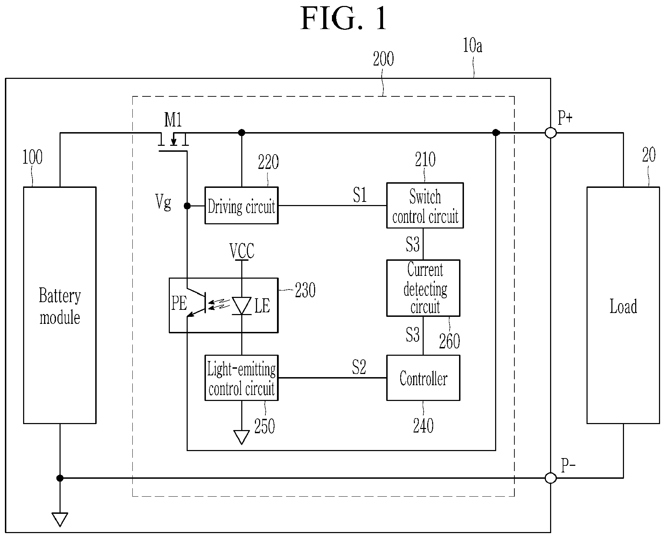

FIG. 1 illustrates a battery pack according to an embodiment.

Referring to FIG. 1, the battery pack 10a according to an embodiment may include pack terminals P+ and P-, a battery module 100, and a battery protection device 200.

The pack terminals P+ and P- are input and output terminals of the battery pack 10a, and the battery pack 10a may be connected to a load 20 or a charger (not shown) through the pack terminals P+ and P-.

The battery module 100 may be connected between the pack terminals P+ and P-, and may include battery cells connected in series or in parallel to each other. The battery module 100 may supply power to the load 20 through the pack terminals P+ and P-.

The battery protection device 200 may include a transistor M1, a switch control circuit 210, a driving circuit 220, a photocoupler 230, a controller 240, a light-emitting control circuit 250, and a current detecting circuit 260.

The transistor M1 may include a first terminal connected to a positive module terminal of the battery module 100, a second terminal connected to the positive pack terminal P+ of the battery pack 10a, and a control terminal. The transistor M1 may be used as a discharge switch for allowing or intercepting a current flow between the battery module 100 and the load 20.

The transistor M1 may be embodied as an N-channel metal oxide semiconductor field effect transistor (MOSFET) with a control terminal, a first terminal, and a second terminal as a gate terminal, a drain terminal, and a source terminal, respectively. Other configurations of the terminals are discussed below. The transistor M1 may be turned on if a voltage (gate-source voltage) between the control terminal and the second terminal is greater than or equal to a threshold value (Vth), and it may be turned off if the voltage (gate-source voltage) is less than the threshold value (Vth).

The switch control circuit 210 may output a control signal S1 for controlling turn-on/turn-off of the transistor M1. The switch control circuit 210 may output a control signal S1 to turn on the transistor M1 if a power supply to the load 20 is needed. The switch control circuit 210 may output the control signal S1 to turn off the transistor M1 if a current that is greater than or equal to a predetermined value flows between the battery module 100 and the load 20 while the transistor M1 is turned on.

The driving circuit 220 may be connected between the control terminal and the second terminal of the transistor M1, and may receive the control signal S1 from the switch control circuit 210. The driving circuit 220 may control turn-on/turn-off of the transistor M1 according to the control signal S1 input by the switch control circuit 210. The driving circuit 220 may generate a control voltage Vg for controlling turn-on/turn-off of the transistor M1 according to the input control signal S1, and may supply the same to the control terminal of the transistor M1. The driving circuit 220 may supply the control voltage Vg for turning on the transistor M1 to the control terminal of the transistor M1 if the control signal S1 input by the switch control circuit 210 instructs turn-on of the transistor M1. The driving circuit 220 may supply the control voltage Vg for turning off the transistor M1 to the control terminal of the transistor M1 if the control signal S1 input by the switch control circuit 210 instructs turn-off the transistor M1.

The photocoupler 230 may include a light-emitting device LE and a light receiving element PE. It may be operated in a turn-on state in which the current flows to the light-emitting device LE to turn on the light receiving element PE, and a turn-off state in which the current flowing to the light-emitting device LE is intercepted to turn off the light receiving element PE. The photocoupler 230 may connect the control terminal of the transistor M1 and the second terminal of the transistor M1 if turned on (or if the light-emitting device LE emits light). Therefore, if the photocoupler 230 is turned on, the transistor M1 may be turned off irrespective of the control signal S1.

The controller 240 may output a control signal S2 for controlling turn-on (turn-on of light emitting of the light-emitting device LE)/turn-off (turn-off of light emitting of the light-emitting device LE) of the photocoupler 230. The controller 240 may output the control signal S2 for turning off the photocoupler 230 in a default state. The controller 240 may output the control signal S2 for turning on the photocoupler 230 if a current that is greater than or equal to a predetermined value flows between the battery module 100 and the load 20 while the transistor M1 is turned on. In this instance, the controller 240 may limit a turn-on time of the photocoupler 230 to a predetermined time to reduce power consumption. That is, the controller 240 may output the control signal S2 to turn off the photocoupler 230 after turning on the photocoupler 230 for a predetermined time.

The light-emitting control circuit 250 may be connected between the photocoupler 230 and an output end of the controller 240. The light-emitting control circuit 250 may receive the control signal S2 from the controller 240, and may control the turn-on/turn-off of the photocoupler 230 according to the control signal S2. The light-emitting control circuit 250 may, if receiving the control signal S2 for instructing turn-off of the photocoupler 230 from the controller 240, intercept the current flow of the light-emitting device LE and may turn off the photocoupler 230. The light-emitting control circuit 250 may allow the current to flow to the light-emitting device LE and turn on the photocoupler 230 if the control signal S2 for instructing turn-on of the photocoupler 230 is input by the controller 240.

The current detecting circuit 260 may detect the current flowing on the current path between the battery module 100 and the pack terminals P+ and P- by using a shunt resistor (not illustrated) connected between the battery module 100 and the pack terminals P+ and P-. The current detecting circuit 260 may output a current detecting signal S3 that corresponds to the detected current value to the controller 240 and the switch control circuit 210. The controller 240 and the switch control circuit 210 having received the current detecting signal S3 may respectively perform an overcurrent detecting function to compare the current value that corresponds to the current detecting signal S3 and a predetermined value, and if the current value is greater than or equal to a predetermined value, they may output the control signals S1 and S2 respectively to turn off the transistor M1.

The gate-source voltage of the transistor M1 may be greater than or equal to a threshold value so that the transistor M1 may be turned on, and for this purpose, the control voltage Vg (i.e., gate terminal voltage) supplied to the gate terminal of the transistor M1 must be greater than the source terminal voltage of the transistor M1 by at least the threshold value Vth. As shown in FIG. 1, if the transistor M1 is on a high side, a use of boosting circuit such as a charge pump may be needed to generate the control voltage Vg. The use of a boosting circuit may generate a delay time for a boosting process and may function as a factor hindering a quick control of the transistor M1. A turn-off delay of the transistor M1 may lead to a damage to the battery pack 10a in a situation where a high short-circuit current is generated instantaneously due to a short circuit outside the battery pack 10a. Therefore, in this embodiment, if an overcurrent situation may occur, a turn-off time of the transistor M1 may be shortened by using the photocoupler 230 to quickly turn off the transistor M1. In addition, power consumption due to the use of the photocoupler 230 may be minimized by limiting the turn-on time of the photocoupler 230 to a predetermined time and allowing the transistor M1 to be controlled by the switch control circuit 210 thereafter.

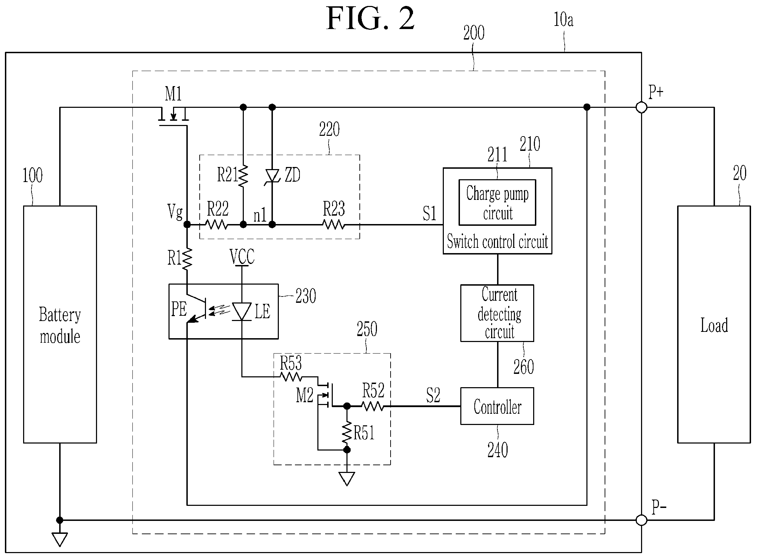

FIG. 2 is a circuit diagram illustrating a configuration of a battery protection device according to an embodiment.

Referring to FIG. 2, regarding the battery protection device 200 according to an embodiment, a switch control circuit 210 may include a charge pump circuit 211. The charge pump circuit 211 may generate a first voltage boosted to be higher than the source terminal voltage of the transistor M1. The first voltage boosted by the charge pump circuit 211 may be used in generating the control signal S1.

If turning on the transistor M1, the switch control circuit 210 may generate a control signal S1 using a first voltage boosted by the charge pump circuit 211 and may output the same to the driving circuit 220. That is, if turning on the transistor M1, the switch control circuit 210 may output the control signal S1 having a voltage level of a first voltage to the driving circuit 220.

If turning off the transistor M1, the switch control circuit 210 may generate a control signal S1 using a second voltage, not a first voltage boosted by the charge pump circuit 211, and may output the same to the driving circuit 220. That is, if turning off the transistor M1, the switch control circuit 210 may output a control signal S1 having a voltage level of a second voltage to the driving circuit 220. The first voltage may be greater than the source terminal voltage of the transistor M1 by at least the threshold value Vth, and the second voltage may be lower than the first voltage. For example, the second voltage may correspond to the source terminal voltage of the transistor M1.

The driving circuit 220 may generate a control voltage Vg according to the control signal S1 output by the switch control circuit 210 and may transmit the control voltage Vg to the gate terminal of the transistor M1. The driving circuit 220 may include a resistor R21 connected between the source terminal of the transistor M1 and a node n1, and a resistor R22 connected between the node n1 and the gate terminal of the transistor M1. In addition, the driving circuit 220 may further include a resistor R23 connected between the node n1 and the output terminal of the switch control circuit 210. The resistor R21 may work as a pull-down resistor, and the resistors R22 and R23 may work as gate resistors for controlling the current input to the gate terminal of the transistor M1.

The driving circuit 220 may further include a Zener diode (ZD) including an anode connected to the source terminal of the transistor M1 and a cathode connected to the node n1 in order to control the gate-source voltage of the transistor M1.

The light-emitting device LE of the photocoupler 230 may be connected between a power node VCC and the light-emitting control circuit 250, and may be connected to a ground or may be disconnected from the ground by the light-emitting control circuit 250. The voltage of the power node VCC may be supplied from a voltage source such as a regulator, a DC-DC converter, or a low voltage battery. The light receiving element PE may be connected between the gate terminal and the source terminal of the transistor M1, and may be turned on by light emission of the light-emitting device LE.

If the photocoupler 230 is controlled to be turned on by the light-emitting control circuit 250, the light-emitting device LE may be connected to the ground, and the light-emitting device LE may emit light by the current flowing through the light-emitting device LE. In addition, the light receiving element PE may be turned on by the light emission of the light-emitting device LE, and the gate terminal and the source terminal of the transistor M1 may be connected to each other by the light receiving element PE. As the gate terminal and the source terminal of the transistor M1 are connected to each other by the light receiving element PE, the transistor M1 may be turned off.

If the photocoupler 230 is controlled to be turned off by the light-emitting control circuit 250, the connection between the light-emitting device LE and the ground may be cut off, so the current flowing through the light-emitting device LE may be intercepted and the light-emitting device LE may stop emitting light. In addition, as light emission of the light-emitting device LE stops, the light receiving element PE may be turned off, and a connection between the gate terminal and the source terminal of the transistor M1 by the light receiving element PE may be blocked. If the connection between the gate terminal and the source terminal of the transistor M1 by the light receiving element PE is blocked, the turn-on/turn-off of the transistor M1 may be controlled by the switch control circuit 210 and the driving circuit 220.

The light-emitting control circuit 250 may include a switch, that is, a transistor M2 connected between the light-emitting device LE of the photocoupler 230 and the ground. The transistor M2 may include a first terminal connected to the light-emitting device LE, a second terminal connected to the ground, and a control terminal for receiving the control signal S2 from the controller 240. Turn-on/turn-off of the transistor M2 may be controlled according to the control signal S2. The transistor M2 may be turned on if the control signal S2 instructs the turn-on of the photocoupler 230, and it may be turned off if the control signal S2 instructs the turn-off of the photocoupler 230. The transistor M2 may block or allow the current flowing to the light-emitting device LE through turn-on/turn-off. If the transistor M2 is turned on, the light-emitting device LE and the ground may be connected, and the current may flow to the light-emitting device LE, thereby turning on the light receiving element PE. If the transistor M2 is turned off, the connection between the light-emitting device LE and the ground may be intercepted, and as a result, the current flowing to the light-emitting device LE may be intercepted and the light receiving element PE may be turned off.

The transistor M2 may be an N-channel MOSFET of which a control terminal may be a gate terminal, and a first terminal and a second terminal may be a drain terminal and a source terminal, respectively. Accordingly, the transistor M2 may be turned on if a voltage that is greater than or equal to the threshold value Vth is applied to the gate terminal, and the transistor M2 may be turned off if a voltage that is less than the threshold value Vth is applied to the gate terminal.

The light-emitting control circuit 250 may further include a resistor R51 connected between the control terminal of the transistor M2 and the ground for a stable operation of the transistor M2, and a resistor R52 connected between the output terminal of the controller 240 and the control terminal of the transistor M2. The light-emitting control circuit 250 may further include a current limiting resistor R53 connected between the light-emitting device LE and the first terminal of the transistor M2.

The battery protection device 200 may further include a resistor R1 connected between the gate terminal of the transistor M1 and the light receiving element PE of the photocoupler 230 for a stable operation of the transistor M1.

Regarding the above-structured battery protection device 200, the switch control circuit 210 and the controller 240 may be integrated into one integrated circuit (IC). In this case, the integrated circuit may further include a current detecting circuit 260, and a regulator for supplying a voltage to the power node VCC.

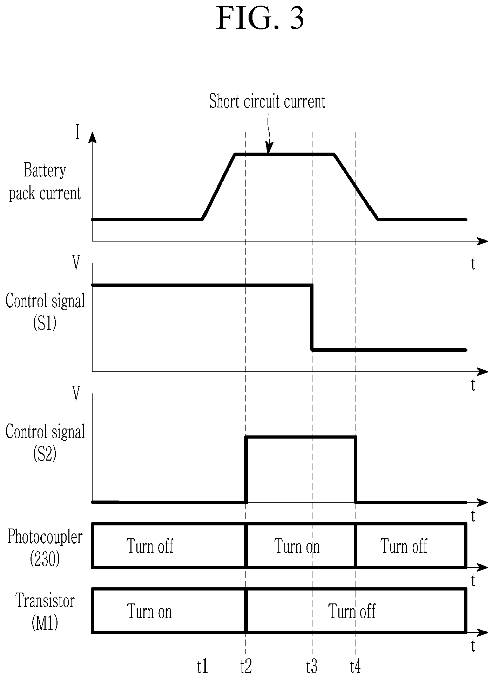

FIG. 3 is a timing diagram illustrating an operation of a battery protection device according to an embodiment.

Referring to FIG. 3, a high short circuit current is momentarily generated at a time t1 because of a short circuit outside the battery pack 10a.

The controller 240 may detect a generation of a short circuit current at a time t2 through an overcurrent detecting function installed therein, may output a control signal S2 for turning on the photocoupler 230, and may turn off the transistor M1.

On the other hand, the switch control circuit 210 may take a predetermined time until the state of the control signal S1 is changed by the charge pump circuit 211, and the switch control circuit 210 may accordingly output a control signal S1 for turning off the transistor M1 at a time t3 delayed by a predetermined time from the time t2 at which the generation of an overcurrent is detected.

To minimize power consumption caused by the use of the photocoupler 230, the controller 240 may turn on the photocoupler 230 for a predetermined time (refer to sections t2 to t4) and may turn it off again at a time t4. Here, as the control signal S1 is changed to indicate the turn-off of the transistor M1 at the time t3, the transistor M1 may continuously maintain the turn-off state if the photocoupler 230 is turned off again at the time t4.

Meanwhile, the case where the controller 240 and the switch control circuit 210 include the overcurrent detecting function has been described as an example in the above embodiment, but according to another embodiment, one of the controller 240 and the switch control circuit 210 may include the overcurrent detecting function.

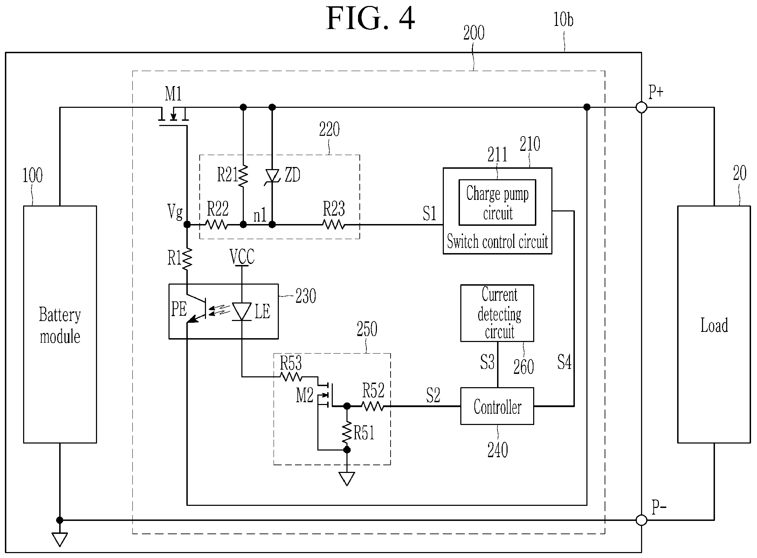

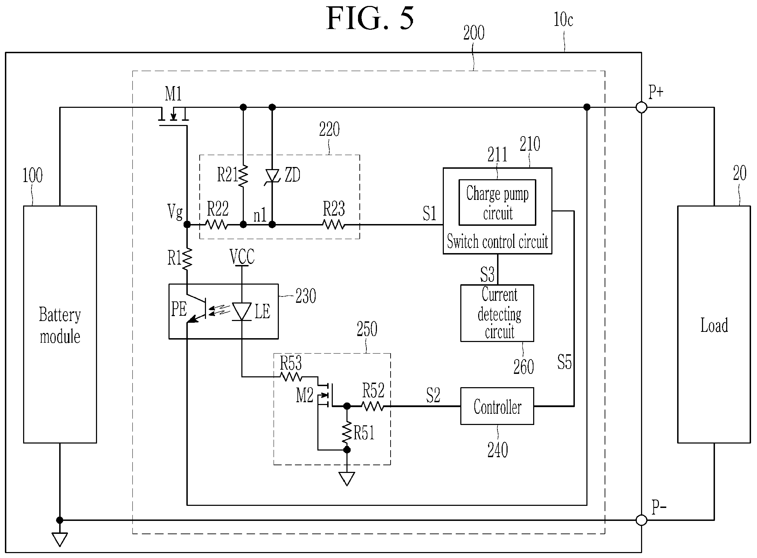

FIG. 4 and FIG. 5 are circuit diagrams schematically illustrating a battery pack according to example embodiments, showing a case in which one of the controller 240 and the switch control circuit 210 includes the overcurrent detecting function.

Referring to FIG. 4 and FIG. 5, if one of the controller 240 and the switch control circuit 210 includes the overcurrent detecting function, the current detecting circuit 260 may transmit the current detecting signal S3 to the device including the overcurrent detecting function from among the controller 240 and switch control circuit 210. In this case, the device receiving the current detecting signal S3 may compare the current value that corresponds to the current detecting signal S3 with a setting value according to the overcurrent detecting function, and may output the control signal S1 or S2 for controlling the transistor M1 according to a comparison result. In addition, this device may transmit the overcurrent detecting signal S4 or S5 to the corresponding device so that the other devices may control the turn-off of the transistor M1 if the current value corresponding to the current detecting signal S3 is greater than or equal to the setting value.

In the example illustrated in FIG. 4, the current detecting circuit 260 of the battery pack 10b may transmit the current detecting signal S3 to the controller 240. Accordingly, the controller 240 receiving the current detecting signal S3 may compare the current value that corresponds to the current detecting signal S3 with a setting value according to the overcurrent detecting function, and may output the control signal S2 for controlling the transistor M1 according to a comparison result. In addition, the controller 240 may transmit the overcurrent detecting signal S4 to the switch control circuit 210 so that the switch control circuit 210 may control the turn-off of the transistor M1 if the current value corresponding to the current detecting signal S3 is greater than or equal to the setting value.

In the example illustrated in FIG. 5, the current detecting circuit 260 of the battery pack 10c may transmit the current detecting signal S3 to the switch control circuit 210. Accordingly, the switch control circuit 210 receiving the current detecting signal S3 may compare the current value that corresponds to the current detecting signal S3 with a setting value according to the overcurrent detecting function, and may output the control signal S1 for controlling transistor M1 according to a comparison result. In addition, the switch control circuit 210 may transmit the overcurrent detecting signal S5 to the controller 240 so that the controller 240 may control the turn-off of the transistor M1 if the current value corresponding to the current detecting signal S3 is greater than or equal to a setting value.

In accordance with the above descriptions, if a high short-circuit current is generated because of an external short circuit, the battery pack 10a, 10b, 10c may be protected from the short-circuit current by quickly intercepting the connection between the battery pack 10a, 10b, 10c and the outside, e.g., a load 20.

Electronic or electrical devices according to embodiments of the present disclosure and/or other related devices or components may be realized by using appropriate hardware, firmware (e.g., an application-specific integrated circuit), software, or combinations of software, firmware, and hardware. For example, various configurations of the above-noted devices may be positioned on one integrated circuit (IC) chip or an individual IC chip. Various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization such as surface metallization and/or pins, and may include conductive polymers or ceramics.

In general, the secondary battery cell may include an electrode assembly including a positive electrode, a negative electrode and a separator between the positive and negative electrodes, a case accommodating the electrode assembly, and an electrode terminal electrically connected to the electrode assembly. An electrolyte may be injected into the case to enable charging and discharging of the battery cell through an electrochemical reaction between the positive electrode, the negative electrode, and the electrolyte solution. A shape of the case, such as a cylindrical shape or a rectangular parallelepiped shape, may depend on a usage of the battery cell.

The secondary battery cells are combined in series or in parallel to form a battery module to provide high energy density. In addition, these battery modules may be combined in series or in parallel to form a battery pack to provide desired voltage, capacity or power density. The battery pack includes a switch for controlling an electrical connection between the battery module and a load/charger. The switch may be positioned on a high side of the battery pack (i.e., a positive output side of the battery pack) or a low side (i.e., a negative output side of the battery pack).

If an external short circuit of output terminals of the battery pack occurs, excessive short circuit current may be generated and the battery pack may be damaged. Therefore, the battery pack must necessarily be equipped with a protection device to protect the battery pack from such a short-circuit current.

In some embodiments, the various configurations of one or more of the devices may be embodied as at least one processor configured so as to perform one or more of the above-described various functions, they may be performed in at least one computing device, and they may be processes or threads for performing computer program instructions and interacting with other system components. The computer program instruction may be stored in a memory realizable in a computing device using a standard memory device such as a random access memory (RAM). The computer program instruction may also be stored in a non-transitory computer readable medium such as a CD-ROM or a flash drive.

A person of ordinary skill in the art will understand that various functions of the computing device may be combined or united to a single computing device, or functions of a specific computing device may be dispersed to at least another computing device while not digressing from the range of the embodiments of the present disclosure.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the present invention as set forth in the following claims.

### <Description of symbols>

10a, 10b, 10c: battery pack
20: load
100: battery module
200: battery protection device
210: switch control circuit
211: charge pump circuit
220: driving circuit
230: photocoupler
240: controller
250: light-emitting control circuit
260: current detecting circuit
M1: transistor

## Claims

1. A battery protection device, comprising:
a first transistor connected between one of pack terminals and a battery module and configured to control flow of a current between the pack terminals and the battery module, the first transistor having a control terminal;
a switch control circuit configured to output a first control signal for turning on or turning off the first transistor;
a controller configured to output a second control signal; and
a photocoupler connected to the control terminal of the first transistor, the photocoupler configured to be turned on or turned off according to the second control signal and to turn off the first transistor if the photocoupler is turned on.

2. The battery protection device as claimed in claim 1, wherein:
the controller is configured to turn on the photocoupler according to the second control signal if the current between the pack terminals and the battery module is greater than or equal to a setting value, and
the first transistor is turned off irrespective of the first control signal if the photocoupler is turned on.

3. The battery protection device as claimed in claim 1 or claim 2, wherein the first transistor is connected between a positive pack terminal from among the pack terminals and a positive module terminal of the battery module.

4. The battery protection device as claimed in claim 3, wherein the first transistor is an N-channel metal oxide semiconductor electric field effect transistor including a drain terminal connected to the positive module terminal, a source terminal connected to the positive pack terminal, and a gate terminal used as the control terminal.

5. The battery protection device as claimed in claim 4, further comprising a driving circuit connected between the gate terminal and the source terminal and configured to adjust a voltage applied to the gate terminal according to the first control signal.

6. The battery protection device as claimed in claim 5, wherein the driving circuit includes:
a first resistor connected between a node for receiving the first control signal and the source terminal, and
a second resistor connected between the node and the gate terminal.

7. The battery protection device as claimed in claim 6, wherein the driving circuit further includes a Zener diode connected between the source terminal and the node for controlling a voltage between the gate terminal and the source terminal.

8. The battery protection device as claimed in any of claims 4 to 7, wherein the photocoupler includes:
a light-emitting device for controlling light emission by the second control signal, and
a light receiving element connected between the gate terminal and the source terminal, the light receiving element being configured to turn on in response to light emission of the light-emitting device, and connecting the gate terminal and the source terminal if the light receiving element is turned on.

9. The battery protection device as claimed in claim 8, further comprising a light-emitting control circuit connected between the light-emitting device and an output end of the controller, and configured to intercept or allow a current flow of the light-emitting device according to the second control signal.

10. The battery protection device as claimed in claim 9, wherein the light-emitting control circuit includes a second transistor on a current path including the light-emitting device, and configured to allow or intercept a current flowing to the light-emitting device according to the second control signal.

11. The battery protection device as claimed in claim 10, wherein:
the second transistor includes a first terminal connected to the light-emitting device, a second terminal connected to a ground, and a control terminal for receiving the second control signal, and
the light-emitting device is connected between a power node and the first terminal of the second transistor.

12. The battery protection device as claimed in any preceding claim, wherein the switch control circuit includes a charge pump circuit, and is configured to generate the first control signal by using a voltage generated by the charge pump circuit.

13. The battery protection device as claimed in claim 12, wherein the switch control circuit is configured to generate the first control signal for turning off the first transistor through the charge pump circuit if the current between the pack terminals and the battery module is greater than or equal to a setting value.

14. A battery pack, comprising:
a battery module, and
the battery protection device as claimed in any preceding claim.
